Europäisches Patentamt

European Patent Office

Office européen des brevets

(11) Publication number: **0 494 635 A2**

# EUROPEAN PATENT APPLICATION

(21) Application number: **92100141.8**

(22) Date of filing: **07.01.92**

(51) Int. Cl.5: **G06K 9/78**

(30) Priority: **07.01.91 JP 243/91**

(43) Date of publication of application:
**15.07.92 Bulletin 92/29**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Kobayashi, Hiroaki**
**615-5-505, Shimo-Kurata-Machi, Totsuka-ku**
**Yokohama-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Pattern recognition method.

(57) An area including a pattern (11) which has an area (X11×Y11) unable to be recognized by a camera at a time is divided into a plurality of divided areas (12a to 12d), the image of each divided area is taken by moving the camera, and a plurality of taken images are synthesized into a single image (A×B) to recognize the pattern. Therefore, it is possible to carry out each inspection item in-process and cost effectively.

F I G . I

EP 0 494 635 A2

## BACKGROUND OF THE INVENTION

The present invention relates to a pattern recognition method, and more particularly to a pattern recognition method suitable for use in die bonding or wire bonding, for detecting a particular area of a semiconductor chip or lead frame and for judging whether bonding or pellet is acceptable or not.

Before and after die bonding or wire bonding, it is necessary to carry out pattern recognition for detecting a particular area of a semiconductor chip or lead frame and for judging whether bonding or pellet is acceptable or not.

The following Table shows inspection items, inspection objects, areas for pattern recognition, and necessary image resolutions, respectively required for executing die bonding and judging its acceptance.

Table

| | | Inspection Item | Inspection Object | Recognition Area (mm$^2$) | Image Resolution |
|---|---|---|---|---|---|
| | 1 | die pellet position | detection of position shift<br>* shift in X direction<br>* shift in Y direction<br>* angle shift | 2.5 × 2 | 7.5 μm/bit |
| | 2 | die pellet acceptability * lack, crack, mirror | outer shape acceptability<br>* lack, crack<br>* mirror pellet | 5 × 3 to 10 × 6 | 15 μm/bit |
| | 3 | die pellet nonacceptance mark | detection of nonacceptance mark | 5 × 3 | 30 μm/bit |
| | 4 | lead frame position | detection of position shift<br>* shift in X direction<br>* shift in Y direction | 2.5 × 2 | 7.5 μm/bit |
| | 5 | die bonding position | detection of position shift | 2.5 × 2 | 7.5 μm/bit |
| | 6 | paste coating position | detection of position shift | 5 × 3 to 15 × 9 | 15 μm/bit |
| | 7 | paste coating area | detection of coating area | 5 × 3 to 15 × 9 | 30 μm/bit |

As seen from Table, a number of inspections are required to be carried out in order to judge the acceptability of die bonding. The size of a recognition area and the resolution change with each inspection item. For example, in order to detect a shift of a die pellet position as in the inspection item (1), or in order to detect a shift of a lead frame position as in the inspection item (4), it is necessary to recognize an area of 2.5 mm$^2$ and provide a resolution of 7.5 μm/bit. In order to judge an acceptability of a die pellet such as lack, crack, or mirror with no pattern formed on the surface and have a mirror surface, as in the inspection item (2), it is necessary to recognize an area of 5 × 3 to 10 × 6 mm$^2$ larger than that for the inspection item (1). In this inspection item (2), it is necessary to provide a resolution of 15 μm/bit. In the inspection item (3), a nonacceptance mark which is given to a die pellet having nonacceptable electric characteristics, is detected. In this inspection item (3), it is necessary to recognize an area 5 × 3 mm$^2$ corresponding to the size of a nonacceptance mark, and to provide a resolution as large as 30 μm/bit. In the inspection item (5), a shift of a die bonding position is detected, with a recognition area of 2.5 × 2 mm$^2$ and a resolution of 7.5 μm/bit. In the inspection item (6), a paste coating position is detected, with a recognition area of 5 × 3 to 15 × 9 mm$^2$ and a resolution of 15 μm/bit. In the inspection item (7), a paste coating area is detected, with a recognition area of 5 × 3 to 15 × 9 mm$^2$ and a resolution of 30 μm/bit.

The sizes of objects to be recognized change with the inspection item. Conventionally, in order to deal with various resolutions and recognition areas, a plurality of optical barrels different in optical magnification factors have been used or an optical barrel having a zoom function has been used. For example, a camera having a high magnification factor and two cameras with a zoom function have been used for inspection of die bonding. However, the optical mechanism is complicated and heavy, and cannot operate at high speed, requiring a long inspection time. Furthermore, controlling a plurality of cameras results in an increase of current consumption. In addition, such apparatus occupies a large space and is expensive. If an optical system is controlled to be capable of inspecting in-process, such a system becomes more complicated and expensive.

2

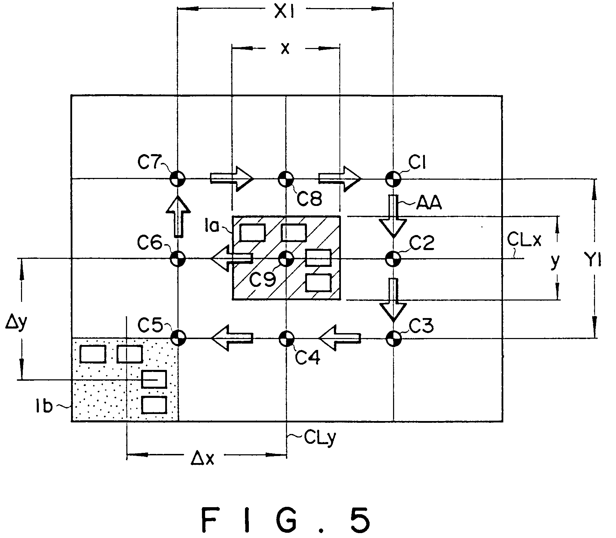

The position recognition for wire bonding has been carried out in the following manner. Fig. 5 shows a pattern matching area 1a having a dimension of x*y. The camera field has a dimension of X1*Y1 larger than the pattern matching area 1a. If the center of the pattern matching area 1a is located at the center c9 of the camera field, then it is possible to locate the pattern matching area within the camera field.

In some cases, the position of the pattern matching area 1a shifts. In order to detect a pattern matching area 1b whose center c9 is shifted by $\Delta x$ in the x-direction and $\Delta y$ in the y-direction, there is provided a detection area magnification function whereby an X-Y table mounting a camera is moved. The center of the camera field is sequentially moved from the center c1 to c8 in the direction of the arrow AA so as to find the pattern matching area 1a from a larger area.

Although this function allows the center c9 of the camera field to be moved to find an object, it cannot deal with various recognition areas and resolutions different for each inspection item.

As described above, a conventional pattern recognizing method for die bonding requires an increased inspection time and cost. Furthermore, it cannot deal with various recognition areas and resolutions required for detecting positions in wire bonding.

## SUMMARY OF THE INVENTION

It is therefore an object of the present invention to provide a pattern recognition method capable of cost-effectively performing various inspections and measurements.

According to the present invention, there is provided a pattern recognition method comprising a first step of dividing an area including a pattern which has an area unable to be recognized by a camera at a time, into a plurality of divided areas, a second step of taking an image of each divided area by moving said camera in parallel with said pattern, and a third step of synthesizing a plurality of taken images into a single image and recognizing said pattern.

An area including a pattern which has an area unable to be recognized by a camera at a time is divided into a plurality of divided areas, the image of each divided area is taken by moving the camera, and a plurality of taken images are synthesized into a single image to recognize the pattern. Therefore, a single optical system can deal with various sizes of recognition areas and resolutions, reducing the inspection cost.

In taking an image of each divided area by moving a camera, an image taking density may be set as desired in accordance with the pattern size and necessary resolution. For example, if the area to be recognized is large but the required resolution is low, then the image taking density is made low, to thereby shorten the image processing time.

A camera can be moved in parallel with a pattern, for example, by mounting the camera on an X-Y stage.

A pattern to be recognized by the camera may be a nonacceptance mark attached to a die pellet, or a paste coated on a lead frame.

## BRIEF DESCRIPTION OF THE DRAWINGS

In the accompanying drawings:

Fig. 1 illustrates division and synthesis of an image area in recognizing a nonacceptance mark by using a pattern recognition method according to an embodiment of the present invention.

Fig. 2 is a schematic diagram showing the structure of an image memory storing image information recognized by the pattern recognition method according to the embodiment.

Fig. 3 is a schematic diagram showing the structure of an image memory storing image information recognized by the pattern recognition method according to the embodiment.

Fig. 4 illustrates the procedure for obtaining the position and area of a coated paste by the pattern recognition method of the embodiment.

Fig. 5 illustrates the operation of increasing the inspection area by using a conventional pattern recognition method.

## DESCRIPTION OF TEE PREFERRED EMBODIMENTS

A pattern recognition method according to an embodiment of the present invention will be described with reference to the accompanying drawings. In this embodiment, of cameras used by a conventional pattern recognition method, a camera with an optical system having the highest resolution and a high magnification factor is mounted on an X-Y stage.

For bonding inspection, if although a high resolution is required, a narrow recognition area is used, for example in the position shift inspection (inspection item (1) in Table), then an object is set within a camera field as in a conventional case. If the object is mounted on a shifted position and outside the camera field, then the X-Y stage is driven to move the camera field and set the object within the camera field.

In the case of a narrow recognition area described above, inspection can be carried out following a procedure similar to the conventional procedure. However, if a broad recognition area is required, such as in the case of detecting a nonacceptance mark of a die pellet (inspection item (3) in Table), the mark cannot be positioned within the camera field because of its high magnification factor. Such inspection is carried out in the following manner.

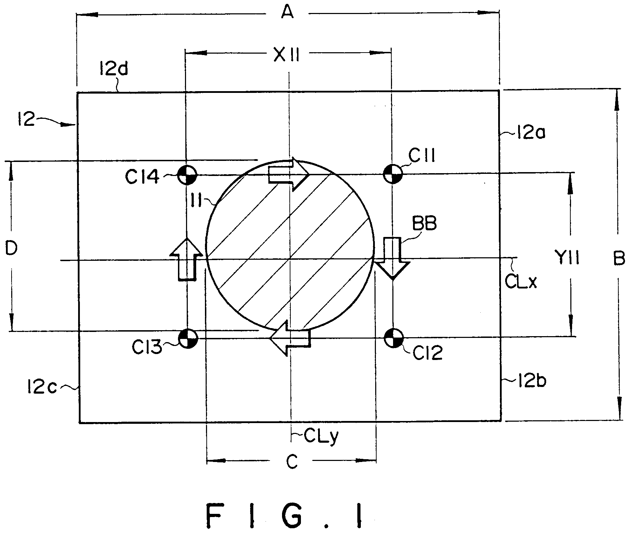

Fig. 1 shows an inspection object, e.g., a nonacceptance mark 11 and a camera field having a dimension of X11*Y11. The nonacceptance mark 11 is observed as black by a camera, and the other area is observed white. If the nonacceptance mark is discriminated based upon whether the whole surface of a pellet is black or white, there is a possibility of an erroneous recognition because such recognition depends upon a change in light quantity and the surface state of a pellet. In view of this, it is judged that there is a nonacceptance mark if a black portion within a white area has an area equal to or larger than a predetermined area.

First, a view field 12 is determined which has a dimension of A*B sufficiently larger than a dimension C*D of the nonacceptance mark. This view field 12 is divided into, e.g., four view fields 12a, 12b, 12c, and 12d. The X-Y stage is sequentially driven so that the camera is located to the centers c11 to c14 of the view fields 12a to 12d, to thereby take four images. Four taken images are synthesized to obtain an image having the dimension of A*B. In this image synthesis, it is necessary to use an image memory having a capacity sufficiently larger than the number of pixels of the camera. The synthesized image contains the view field 12 so that the nonacceptance mark 11 can be detected.

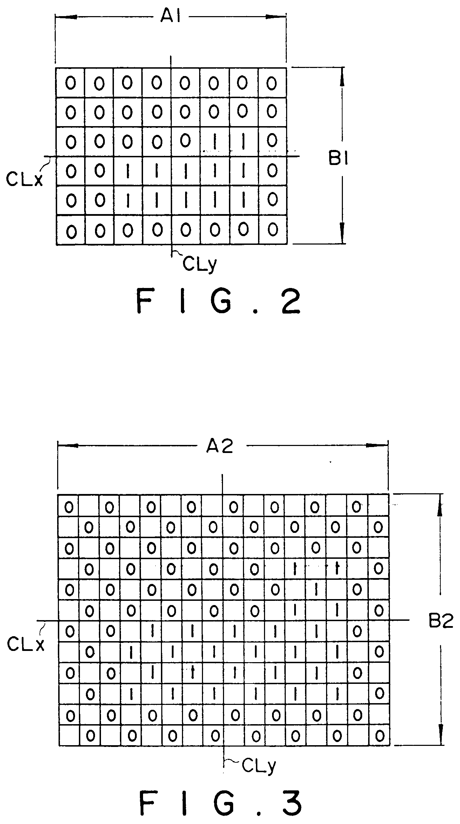

If pattern recognition is carried out with respect to the synthesized image, the image processing time becomes longer as the number of pixels increases and the capacity of the image memory increases. The image processing time can be shortened by changing the density of pixels in accordance with the type of inspection. Fig. 2 is a schematic diagram showing the structure of an image memory storing an image having a dimension A1*B1 taken by a fixed camera. "1" and "0" in Fig. 2 indicate the information contents stored in each cell. The information to be processed includes horizontal 8 bits × vertical 6 bits = 48 bits.

Fig. 3 is a schematic diagram showing the structure of an image memory storing an image having a dimension A2*B2 comprised by a plurality of images taken by moving a camera, in accordance with the pattern recognition method of the embodiment. If the image information is to be stored in the same manner as described with Fig. 2, the information amount becomes horizontal 16 bits × vertical 12 bits = 192 bits. In contrast, if every second information bit is stored as shown in Fig. 3, the information amount becomes horizontal 8 bits × vertical 6 bits = 48 bits, reducing to one fourth the former information amount, considerably shortening the image processing time. The resolution is lowered to one second that shown in Fig. 2. However, no practical problem occurs since the lower resolution of the optical system is used in inspecting a large area recognition.

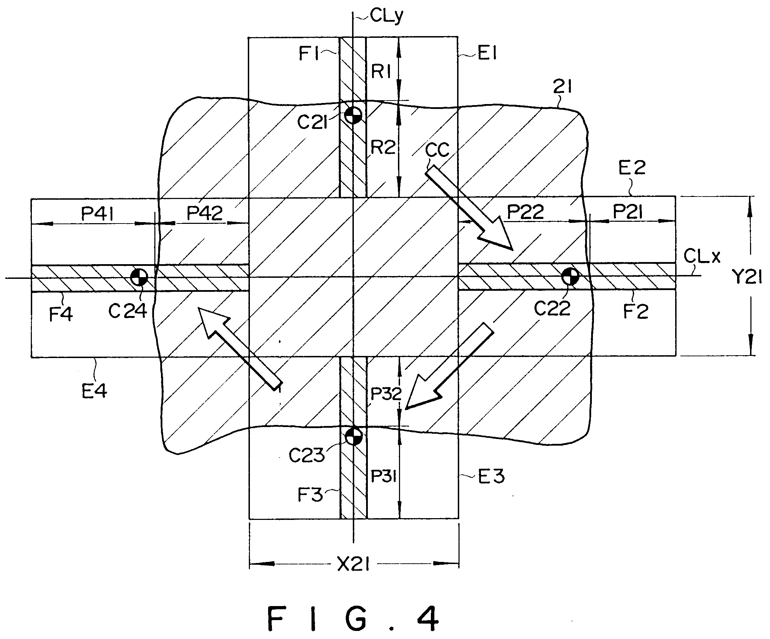

Next, there will be described the procedure of inspecting a paste coating position (inspection item (6) in Table) and inspecting the coating area (inspection item (7)) by using the pattern recognition method of the present embodiment. Fig. 4 shows a paste 21 coated on a lead frame. The area of the paste 21 is not inspected directly, but it is indirectly estimated from the length of a coated area within each four peripheral areas E1 to E4. The center of the camera field is sequentially moved to centers C21, C22, C23, and C24 by driving the X-Y stage. When the center of the camera field is located at the center C21, an image of the area E1 is taken in an image memory. The area with paste coated is recognized as black, and the area without paste coated is recognized as white. There are therefore obtained a length P12 of the area recognized black and a length P11 of the area recognized white, respectively extending along the center line CLy. Similarly, when the center of the camera field is located at the center C22, an image of the area F2 is taken in the image memory. There are therefore obtained a length P22 of the area recognized black and a length P21 of the area recognized white, respectively extending along the center line CLx. When the camera moves to the center C23, within the area F3, there are obtained a length P32 of the area recognized black and a length P31 of the area recognized white, respectively extending along the center line CLy. When the camera moves to the center C24, within the area F4, there are obtained a length P42 of the area recognized black and a length P41 of the area recognized white, respectively extending along the center line CLx.

In the above manner, the ratio of the coated area to the non-coated area of each area F1 to F4 is obtained (P12:P11, P22:P21, P32:P31, P42:P41). For example, assuming that a ratio of 50:50 is acceptable, then a ratio 40:60 means a shift of a coated area position by 10%. In such a manner, the paste coating position and area are inspected.

According to the present embodiment, a single camera and optical system can deal with various sizes of recognition areas and resolutions for different inspection items. As a result, pattern recognition can be carried out by using a simple and compact apparatus, reducing the inspection cost.

The above embodiment has been described by way of example only, and the present invention is not limited thereto. For example, the number of divided areas of a pattern to be recognized is set as desired. Even if the peripheral portions of divided areas are superposed one upon another, there is no problem in synthesis into a single image.

Reference signs in the claims are intended for better understanding and shall not limit the scope.

## Claims

1.  In a method of recognizing a pattern using a camera, a pattern recognition method comprising:

    a first step of dividing an area (12, 21) including a pattern (11, 21) which has an area ($X11 \times Y11$, $X21 \times Y21$) unable to be recognized by a camera at a time, into a plurality of divided areas;

    a second step of taking an image of each divided area (12a-12d, E1-E4) by moving said camera in parallel with said pattern (11, 21); and

    a third step of synthesizing a plurality of taken images into a single image ($A \times B$, F1-F4) and recognizing said pattern (11, 21).

2.  A pattern recognition method according to claim 1, wherein in said second step, an image taking density is determined in accordance with the size of said pattern (11, 21) and necessary resolution.

3.  A pattern recognition method according to claim 1, wherein in said second step, said camera is mounted on an X-Y state movable in an X-Y plane to move said camera.

4.  A pattern recognition method according to claim 1, wherein said pattern is a nonacceptance mark (11) attached to a die pellet, or a paste (21) coated on a lead frame.

F I G . I

F I G . 2

F I G . 3

CLy

F1 · R1 · E1

21

C21 · R2

CC · E2

P41 · P42 · P22 · P21 · CLx · Y21

F4 · C24 · C22 · F2

E4 · P32

P31 · C23 · E3

F3

X21

F I G . 4

# F I G . 5